# EUROPÄISCHE PATENTANMELDUNG

(11) **EP 4 586 307 A1**
(43) Veröffentlichungstag der Anmeldung: **16.07.2025**
(21) Anmeldenummer: 24150886.0
(22) Anmeldetag: 09.01.2024
(51) Int. Cl.: H01L 21/66

(54) **VERFAHREN ZUR IDENTIFIZIERUNG DER URSACHE VON VERUNREINIGUNGEN VON SCHEIBEN AUS HALBLEITERMATERIAL**

(71) Anmelder: Siltronic AG, 81677 München (DE)
(72) Erfinder: Ehlert, Andreas, 84547 Emmerting (DE)
(74) Vertreter: Hasenhütl, Eva

(57) **Zusammenfassung**

Verfahren zur Identifizierung der Ursache von Verunreinigungen von Scheiben aus Halbleitermaterial, umfassend die folgenden Schritte:
(i) Auswählen mindestens einer Scheibe aus Halbleitermaterial;
(ii) Identifizieren der Positionen und Größen von Oberflächendefekten auf der mindestens einen, ausgewählten Scheibe aus Halbleitermaterial mittels Lichtstreumessung;
(iii) Auswählen mindestens eines der im Schritt (ii) identifizierten Oberflächendefekte und Bestimmen der chemischen Zusammensetzung mindestens eines Teils des ausgewählten mindestens einen Oberflächendefektes mittels Sekundärionen-Massenspektrometrie; und
(iv) Identifizieren eines Prozessschrittes im verwendeten Herstellungsprozess der Scheiben aus Halbleitermaterial, in dem ein Werkstoff, ein Hilfsstoff oder eine Verunreinigung auftritt, die ein Fremdmaterial mit der bestimmten chemischen Zusammensetzung umfasst.

## Beschreibung

### Technisches Gebiet

Die vorliegende Erfindung betrifft ein Verfahren zur Identifizierung der Ursache von Verunreinigungen von Scheiben aus Halbleitermaterial und ein Verfahren zur Herstellung von Scheiben aus Halbleitermaterial.

### Stand der Technik

Scheiben aus Halbleitermaterial, beispielsweise Scheiben aus monokristallinem Silizium (Siliziumwafer), werden in einer Vielzahl von Prozessschritten hergestellt, die unter anderem das Ziehen eines Einkristallstabs aus einer Schmelze, das Zersägen des Kristalls in Scheiben, das Schleifen, das Kantenverrunden, das Polieren und das chemische Reinigen der Scheiben umfassen. Während der Herstellung von Bauelementen auf besagten Halbleiterscheiben werden thermische Prozesse und komplexe Beschichtungsschritte durchgeführt, die eine hohe Reinheit der Oberfläche und insbesondere die weitgehende Abwesenheit von Fremdmaterial an der Oberfläche erfordern.

Um Sicherzustellen, dass die Scheiben aus Halbleitermaterial den hohen Qualitätsanforderungen genügen, ist eine strenge Prozesskontrolle und Inspektion der produzierten Scheiben, insbesondere im Hinblick auf das Vorhandensein von Fremdmaterial und Partikeln an der Oberfläche, erforderlich. Zusätzlich ist es erforderlich, die Quelle der Verunreinigungen im Herstellungsprozess zu identifizieren, um den Herstellungsprozess entsprechend korrigieren zu können.

Ein gängiges Verfahren zur Oberflächeninspektion von Scheiben aus Halbleitermaterial beruht auf dem Prinzip der Lichtstreuung. Die Inspektion von Scheiben aus Halbleitermaterial hinsichtlich Kontamination und Beschädigung mit Hilfe von optischen Verfahren ist beispielsweise in der US RE37,740 E beschrieben, die ein Streulichtinspektionsgerät, mit dem die Oberfläche einer schnell rotierenden Scheibe mit einem Laser abgetastet wird, beschreibt. Solche Streulichtmess-Systeme liefern unter anderem Informationen über die Position der Defekte auf der Scheibenoberfläche sowie deren Größe. Diese Information wird in der Regel in elektronischer Form gespeichert, zumeist in einem standardisierten Dateiformat, so dass diese Information auch für nachfolgende analytische Messungen der Scheibe auf anderen Messgeräten zur Verfügung steht. Ein solches standardisiertes Dateiformat ist KLARF **(KLA R**eview **F**ile **F**ormat), welches Informationen über die Positionen von Defekten auf der Oberfläche einer Halbleiterscheibe und zusätzlich die Position dieser Defekte bezogen auf verschiedene Messgeräte speichert. Jedoch reicht das Ergebnis einer Lichtstreumessung in der Regel nicht aus, um Aussagen über die Ursachen des gefundenen Defektes treffen zu können.

Zumeist wird eine Analyse der chemischen Zusammensetzung der Fremdmaterialien durchgeführt, die zur Identifizierung ihrer Entstehungsursache herangezogen wird. Brundle et al. Characterization and Metrology for ULSI Technology: 1998 International Conference. Proceedings., CP449, 677ff nennt als Standardverfahren zur Analyse von Oberflächendefekten auf Scheiben aus Halbleitermaterial u.a. die optische Mikroskopie, die Raster-Elektronenmikroskopie (REM) mit verknüpften Analysatoren wie EDX (energiedispersive Röntgenspektroskopie), spektroskopische Verfahren sowie die Mikro-Raman Spektroskopie oder die Rasterkraftmikroskopie (AFM). Die Analysenmethoden REM-EDX identifiziert die Chemie des Hauptelements einer Verunreinigung beziehungsweise eines Partikels auf der Oberfläche einer Scheibe aus Halbleitermaterial, jedoch bleibt der Ort ihrer Entstehung unbekannt, da das Hauptelement gewöhnlich in verschiedenen Werk- und Hilfsstoffen in einer Fertigungslinie für Scheiben aus Halbleitermaterial vorkommt.

Allen vorab genannten Ansätzen aus dem Stand der Technik ist gemein, dass sie eine Information zum chemischen Hauptelement beziehungsweise des Hauptbestandteils von Kontaminationen auf Halbleiterscheiben liefern, jedoch nur bedingt dazu beitragen, die Ursache einer Kontamination, d.h. ihren Entstehungsort zu identifizieren, insbesondere bei nicht organischen Kontaminationen. Auch die chemische Zusammensetzung einer Verunreinigung kann mit diesen Methoden in der Regel nicht mit ausreichender Genauigkeit bestimmt werden.

### Technische Aufgabe der Erfindung und deren Lösung

Aufgabe der vorliegenden Erfindung ist die Bereitstellung eines Verfahrens zur Identifizierung der Ursache von Verunreinigungen von Scheiben aus Halbleitermaterial, welches es ermöglicht, die Quelle der Verunreinigung in einem Prozess zur Herstellung von Scheiben aus Halbleitermaterial zu bestimmen, so dass diese beseitigt werden kann.

Gemäß dem ersten Aspekt der vorliegenden Erfindung wird dieses Problem gelöst durch ein Verfahren zur Identifizierung der Ursache von Verunreinigungen von Scheiben aus Halbleitermaterial, welches die folgenden Schritte umfasst:
(i) Auswählen mindestens einer Scheibe aus Halbleitermaterial;
(ii) Identifizieren der Positionen und Größen von Oberflächendefekten auf der mindestens einen, ausgewählten Scheibe aus Halbleitermaterial mittels Lichtstreumessung;
(iii) Auswählen mindestens eines der im Schritt (ii) identifizierten Oberflächendefekte und Bestimmen der chemischen Zusammensetzung mindestens eines Teils des ausgewählten mindestens einen Oberflächendefektes mittels Sekundärionen-Massenspektrometrie (SIMS); und
(iv) Identifizieren eines Prozessschrittes im verwendeten Herstellungsprozess der Scheiben aus Halbleitermaterial, in dem ein Werkstoff, ein Hilfsstoff oder eine Verunreinigung auftritt, die ein Fremdmaterial mit der bestimmten chemischen Zusammensetzung umfasst.

Bevorzugte Ausführungsformen sind Gegenstand der abhängigen Ansprüche.

In einem zweiten Aspekt ist die vorliegende Erfindung auf ein Verfahren zur Herstellung von Scheiben aus Halbleitermaterial gerichtet. Dieses Verfahren umfasst die folgenden Schritte:
Ziehen eines Einkristallstabs aus Halbleitermaterial gemäß dem Czochralski-Verfahren;
Schleifen des Einkristallstabs;
Sägen des geschliffenen Einkristallstabs in Scheiben;
Schleifen und/oder Läppen der Scheiben;
Polieren der Scheiben; und
chemisches Reinigen der Scheiben,
dadurch gekennzeichnet, dass das Verfahren gemäß dem ersten Aspekt der vorliegenden Erfindung stichprobenartig im Rahmen der Prozesskontrolle durchgeführt wird.

### Kurzbeschreibung der Figuren

**Fig. 1** zeigt ein mit einem Rasterelektronenmikroskop aufgenommenes Bild eines Partikels auf der Oberfläche einer Scheibe aus einkristallinem Silizium.
**Fig. 2** zeigt das EDX-Spektrum der als EDS-Spot 1 gekennzeichneten Position des in Fig. 1 abgebildeten Partikels.
**Fig. 3** zeigt das Massenspektrum als Ergebnis der SIMS-Analyse an der als EDS-Spot 1 gekennzeichneten Position des in Fig. 1 abgebildeten Partikels.
**Fig. 4** zeigt ein mit einem Rasterelektronenmikroskop aufgenommenes Bild eines Partikels auf der Oberfläche einer Scheibe aus einkristallinem Silizium.
**Fig. 5** zeigt das EDX-Spektrum der als EDS-Spot 1 gekennzeichneten Position des in Fig. 4 abgebildeten Partikels.
**Fig. 6** zeigt das Massenspektrum als Ergebnis der SIMS-Analyse an der als EDS-Spot 1 gekennzeichneten Position des in Fig. 4 abgebildeten Partikels.

### Detaillierte Beschreibung der Erfindung

Zunächst wird im Schritt (i) des erfindungsgemäßen Verfahrens mindestens eine Scheibe aus Halbleitermaterial ausgewählt. Wenn mehr als eine Scheibe ausgewählt wird, werden die Schritte (ii) bis (iv) bevorzugt für jede der ausgewählten Scheibe durchgeführt.

Scheiben aus Halbleitermaterial im Sinne der vorliegenden Erfindung sind beispielsweise Scheiben aus einkristallinem Silizium, die wahlweise dotiert ist. Die Scheiben aus Halbleitermaterial haben vorzugsweise einen Durchmesser von 150 bis 450 mm, besonders bevorzugt 200 mm oder 300 mm, am meisten bevorzugt 300 mm. Die Scheiben aus Halbleitermaterial können auch eine oder mehrere epitaktisch abgeschiedenen Schichten ausgewählt aus Silizium, Germanium, Galliumnitrid, oder Galliumaluminiumnitrid aufweisen.

Im Schritt (ii) des erfindungsgemäßen Verfahrens erfolgt für jede der mindestens einen ausgewählten Scheiben eine Lichtstreumessung, mittels der die Positionen und Größen von Oberflächendefekten auf der Oberfläche der jeweiligen Scheibe aus Halbleitermaterial identifiziert werden. Dabei kann die Vorderseite und/oder die Rückseite der Scheibe untersucht werden, vorzugsweise die Vorderseite. Die Lichtstreumessung wird dabei vorzugsweise auf kommerziell erhältlichen Lichtstreumess-Systemen der Hersteller KLA Tencor Corp. oder Hitachi High-Tech Corp. durchgeführt. Die Lichtstreumessung wird vorzugsweise unter Reinraumbedingungen betrieben und liefert unter anderem die Koordinaten von Defekten auf den Scheiben aus Halbleitermaterial. Die Koordinaten können als Datensatz in Form einer KLARF-Datei festgehalten und gespeichert werden.

Im Schritt (iii) des erfindungsgemäßen Verfahrens wird mindestens einer der im Schritt (ii) identifizierten Oberflächendefekte ausgewählt und die chemische Zusammensetzung des mindestens einen Teils des ausgewählten mindestens einen Oberflächendefektes mittels Sekundärionen-Massenspektrometrie bestimmt. Vorzugseise erfolgt im Schritt (iii) das Auswählen mindestens eines der im Schritt (ii) identifizierten Oberflächendefekte mittels energiedispersive Röntgenspektroskopie.

In einer bevorzugten Ausführungsform erfolgt also zunächst das Bestimmen der chemischen Zusammensetzung mindestens eines Teils des ausgewählten mindestens einen Oberflächendefektes mittels energiedispersiver Röntgenspektroskopie (EDX). Diese Methode hat den Vorteil, dass sie im Gegensatz zur Sekundärionen-Massenspektrometrie die Probe nicht durch den Beschuss mit Sekundärionen zerstört. Außerdem ist die Analyse der Hauptelemente mittels energiedispersive Röntgenspektroskopie (EDX) ein verhältnismäßig schnelles Analyseverfahren. Vor allem aber ist die energiedispersive Röntgenspektroskopie geeignet, die Hauptelemente eines Oberflächendefekts relativ schnell zu bestimmen. Damit kann mittels energiedispersiver Röntgenspektroskopie ein Oberflächendefekte, oder ein Teil eines Oberflächendefektes, ausgewählt werden, dessen chemische Zusammensetzung dann mittels Sekundärionen-Massenspektrometrie genauer bestimmt werden kann. Somit eignet sich die Bestimmung der chemischen Zusammensetzung mittels energiedispersive Röntgenspektroskopie als Mittel zur Selektion oder Vorauswahl eines oder mehrere Oberflächendefekte oder eines oder mehrere Teile des einen oder mehreren Oberflächendefektes für die genauere Analyse mittels Sekundärionen-Massenspektrometrie. Das Auswählen mindestens eines der im Schritt (ii) identifizierten Oberflächendefekte aus Halbleitermaterial im Schritt (iii) erfolgt also vorzugsweise mittels energiedispersive Röntgenspektroskopie.

Vorteile der Sekundärionen-Massenspektrometrie sind (i) die geringe Eindringtiefe der Ionen, die, zu einer hohen Oberflächenempfindlichkeit führt; und (ii) die hohe Empfindlichkeit bei der Detektion verschiedener chemischer Elemente, also die relativ niedrige Nachweisgrenze eines chemischen Elements, die es erlaubt bestimmte Elemente zu detektieren die mit anderen Methoden, beispielsweise der energiedispersive Röntgenspektroskopie, nicht nachweisbar sind. Wird ein Sekundärionen-Massenspektrometrie-Gerät mit einem Rasterelektronenmikroskop kombiniert, kann die hohe Oberflächenempfindlichkeit und die hohe Empfindlichkeit bei der Detektion verschiedener chemischer Elemente zusätzlich mit einer hohen lateralen Auflösung kombiniert werden. Vorzugsweise liegt die laterale Auflösung im Bereich von 50 nm bis 1 µm, mehr bevorzugt 50 nm bis 500 nm, am meisten bevorzugt 50 nm bis 200 nm. Außerdem kann durch die visuelle Begutachtung der Scheibe mit dem Rasterelektronenmikroskop ein geeigneter Teil eines Oberflächendefektes ausgewählt werden, für den die chemische Zusammensetzung mittels Sekundärionen-Massenspektrometrie bestimmt werden soll. Vorzugsweise hat der mindestens eine Teils des ausgewählten mindestens einen Oberflächendefektes, für den die chemische Zusammensetzung bestimmt wird, einen maximalen Durchmesser im Bereich von 50 nm bis 500 nm. Vorzugsweise wird der Schritt (iii) mit Hilfe eines Rasterelektronenmikroskops, das mit einem Sekundärionen-Massenspektrometrie-Gerät ausgestattet ist, durchgeführt. Optional ist das Rasterelektronenmikroskops zusätzlich mit einem Detektor für energiedispersive Röntgenspektroskopie ausgestattet.

Für die Durchführung des Schrittes (iii) kann die KLARF-Datei auf ein kommerziell erhältliches Rasterelektronenmikroskop übertragen werden. Dadurch können einzelne im Schritt (ii) detektierte Oberflächendefekte im Schritt (iii) gezielt identifiziert und für weitere Untersuchungen, beispielsweise die Bestimmung der chemischen Zusammensetzung, ausgewählt werden.

Die Verwendung eines Rasterelektronenmikroskops, das mit einem Sekundärionen-Massenspektrometrie-Gerät ausgestattet ist, ermöglicht also eine hohe laterale Auflösung und Abbildungsqualität. So kann durch die Kombination der Analysemethoden der Rasterelektronenmikroskopie mit der Sekundärionen-Massenspektrometrie die chemische Zusammensetzung auf der Oberfläche einer Scheibe aus Halbleitermaterial mit einer laterale Auflösung von bis zu 50 nm bestimmt werden. Außerdem weist die Sekundärionen-Massenspektrometrie im Vergleich zu anderen Analysemethoden, die mit einem Elektronenmikroskop kombiniert werden können, beispielsweise der energiedispersiven Röntgenspektroskopie, der Mikro-Raman-Spektroskopie oder der Photinudced Force Microscopy, eine höhere Empfindlichkeit auf.

Wie bereits erwähnt zeichnet sich die Sekundärionen-Massenspektrometrie durch eine hohe Genauigkeit und eine sehr niedrige Nachweisgrenze aus. Dies bedeutet, dass aufgrund der hohen lateralen Auflösung und der hohen Empfindlichkeit bestimmte chemische Elemente in kleinen Partikeln auf der Oberfläche der Scheiben nachweisbar sind, die mit anderen Methoden nicht detektiert werden können. Somit kann die chemische Zusammensetzung von Fremdmaterialien, insbesondere von kleinen Partikeln aus Fremdmaterial, auf der Oberfläche der Scheibe aus Halbleitermaterial genauer als mit anderen Methoden bestimmt werden. Dies erleichtert wiederum die Identifikation des Fremdmaterials und damit die Identifikation der Ursache der Verunreinigung. Vorzugsweise wird zur Sekundärionen-Massenspektrometrie ein Gerät des TYPS EQS Herstellers Hiden Analytical verwendet und dieses mit eine Rasterelektronenmikroskop des Typs AURIGA des Herstellers Zeiss gekoppelt. Ein SIMS-Gerät besteht üblicherweise aus einer lonenkanone, einer Einheit, die die Ionen beschleunigt und auf die Probe fokussiert, einem Energiefilter, einem Massenspektrometer und einer Detektionseinheit. Dabei wird ein Primärstrahl aus energiereichen Ionen, typischerweise im Bereich von 500eV bis 30keV verwendet. Bei der Sekundärionen-Massenspektrometrie handelt es sich um eine Analysemethode, die die Oberfläche der Scheibe beinträchtigen und zerstören kann und außerdem verhältnismäßig langwierig ist. Aus diesem Grund muss aus Gründen der Wirtschaftlichkeit die Anzahl der Scheiben, die mit dieser Methode untersucht werden, möglichst geringgehalten werden. Dies verringert die Anzahl der durch die Analyse zerstören Scheiben und zudem die Dauer des Verfahrens. Somit kann die Wirtschaftlichkeit der Prozesskontrolle erhöht werden, indem die Anzahl der mit SIMS untersuchten Scheiben möglichst geringgehalten wird. Dies kann beispielsweise durch die Verwendung einer Datenbank erfolgen, die es erlaubt, die chemische Zusammensetzung einem bestimmten Fremdmaterial oder eine Gruppe von Fremdmaterialien zuzuordnen.

Optional kann im Schritt (iii) des erfindungsgemäßen Verfahrens zusätzlich das Isotopenverhältnis von einem oder mehreren detektierten chemischen Elementen der chemischen Zusammensetzung mittels Sekundärionen-Massenspektrometrie bestimmt werden. Das Isotopenverhältnis kann zur Bestimmung des Fremdmaterials herangezogen werden. So ist die Isotopensignatur für bestimmte Materialien und deren Herkunft charakteristisch. Somit erleichtert die Bestimmung des Isotopenverhältnisses von einem oder mehreren der detektierten chemischen Elemente in der chemischen Zusammensetzung die Identifikation des Fremdmaterials.

Im Schritt (iv) des erfindungsgemäßen Verfahrens erfolgt das Identifizieren eines Prozessschrittes im verwendeten Herstellungsprozess der Scheiben aus Halbleitermaterial, in dem ein Werkstoff, ein Hilfsstoff oder eine Verunreinigung auftritt, die ein Fremdmaterial mit der bestimmten chemischen Zusammensetzung umfasst.

Dafür kann beispielsweise zunächst eine Zuordnung der im Schritt (iii) bestimmten chemischen Zusammensetzung zu einem Fremdmaterial vorgenommen werden, beispielsweise mithilfe einer Datenbank. Wenn das Isotopenverhältnis von einem oder mehreren detektierten Elementen der chemischen Zusammensetzung bestimmt wurde, kann das Isotopenverhältnis beim Zuordnen der chemischen Zusammensetzung zu einem Fremdmaterial berücksichtigt werden. Das Fremdmaterial kann beispielsweise eine Metalllegierung, eine organische Verbindung oder ein Halbleitermaterial sein. Ein Fremdmaterial im Sinne der vorliegenden Erfindung ist ein Material, das eine andere chemische Zusammensetzung als das Halbleitermaterial der mindestens einen ausgewählten Scheiben aus Halbleitermaterial hat. Die Verunreinigung kann beispielsweise ein Halbleitermaterial sein, das von einer anderen Scheibe aus einem anderen Halbleitermaterial stammt. Solche Verunreinigungen können beispielsweise durch mechanische Abtragung von Material von einer anderen Scheibe aus einem anderen Halbleitermaterial in die Produktionslinie eingebracht werden.

Wenn der chemischen Zusammensetzung ein Fremdmaterial zugeordnet werden kann, kann ein Prozessschritt im verwendeten Herstellungsprozess der Scheiben aus Halbleitermaterial identifiziert werden, in dem ein Werkstoff oder ein Hilfsstoff eingesetzt wird, der das Fremdmaterial umfasst. Dafür kann beispielsweise die Datenbank herangezogen werden, die die chemische Zusammensetzung verschiedener Fremdmaterialien, und optional das Isotopenverhältnis eines oder mehrere Elemente der chemischen Zusammensetzung, angibt. Vorzugsweise enthält die Datenbank außerdem Massenspektren der Fremdmaterialien. Vorzugsweise gibt die Datenbank auch an, in welchen Werk- und Hilfsstoffen ein bestimmtes Fremdmaterial verwendet wird oder als Verunreinigung auftritt. In einer besonders bevorzugten Ausführungsform gibt die Datenbank zusätzlich an, in welchen anderen Produkten, insbesondere in welchen anderen Halbleitermaterialien, ein bestimmtes Fremdmaterial verwendet wird.

Alternativ oder zusätzlich zu einer Datenbank kann auch Fachliteratur und das allgemeine Fachwissen eines Fachmanns für jeden Prozessschritt herangezogen werden, um herauszufinden, in welchem Prozessschritt die Scheibe aus Halbleitermaterial mit dem Fremdmaterial in Kontakt kommt.

Um den Prozessschritt zu identifizieren, in dem ein Fremdmaterial mit der bestimmten chemischen Zusammensetzung eingebracht wird, können die Schritte (i) bis (iii) auch für verschiedene Scheiben aus Halbleitermaterial durchgeführt werden, die nach verschiedenen Prozessschritten aus der Produktionslinie entnommen werden. In diesem Fall wird im Schritt (iii) jeweils gezielt nach Oberflächendefekten gesucht, die die bestimmte chemische Zusammensetzung aufweisen.

Dazu können im Schritt (i) mehrere Scheiben aus Halbleitermaterial ausgewählt werden, die nach unterschiedlichen Prozessschritten aus dem Herstellungsprozess entnommen werden, beispielsweise vor dem Polierschritt, nach dem Polierschritt, nach der chemischen Reinigung und nach der Verpackung oder vor und nach bestimmten Schritten des Handlings, also der Handhabung der Scheiben durch verschiedene Vorrichtungen wie Greifern. Die Schritte (ii) und (iii) können für jede der ausgewählten Scheiben aus Halbleitermaterial durchgeführt werden. Im Schritt (iii) können für jede der ausgewählten Scheiben aus Halbleitermaterial Oberflächendefekte mit der gleichen, bestimmten chemischen Zusammensetzung gesucht werden.

In einer bevorzugten Ausführungsform wird der Schritt (iii) zunächst für eine Scheibe, vorzugsweise diejenige Scheibe der ausgewählten Scheiben, die die meisten Prozessschritte des Herstellungsprozesses durchlaufen hat, durchgeführt und eine bestimmte, chemische Zusammensetzung identifiziert. Anschließend wird der Schritt (iii) für die verbleibenden ausgewählten Scheiben aus Halbleitermaterial durchgeführt, wobei im Schritt (iii) gezielt ein Oberflächendefekt oder ein Teil eines Oberflächendefektes gesucht wird, der die bestimmte chemische Zusammensetzung aufweist. Dabei kann auch schon für die Scheibe, für die der Schritt (iii) zuerst durchgeführt wird, gezielt nach einer bestimmten chemischen Zusammensetzung gesucht werden, beispielsweise der Zusammensetzung eines bestimmten Fremdmaterials. Grundsätzlich kann der Schritt (ii) für alle ausgewählten Scheiben nacheinander, und bevor der Schritt (iii) für eine der ausgewählten Scheiben durchgeführt wird, stattfinden. Alternativ können aber auch für jede der ausgewählten Scheiben die Schritte (ii) und (iii) nacheinander durchgeführt werden.

Auf diese Weise kann ein Prozessschritt identifiziert werden, vor welchem die bestimmte chemische Zusammensetzung noch nicht auf der Oberfläche Scheibe auffindbar ist und nach welchem die bestimmte chemische Zusammensetzung auf der Oberfläche der Scheibe detektierbar ist. Dieses Vorgehen erlaubt es, den Schritt ausfindig zu machen, in dem das Fremdmaterial mit der bestimmten chemischen Zusammensetzung in Kontakt mit der Oberfläche der Scheibe aus Halbleitermaterial kommt.

Gemäß dem zweiten Aspekt der vorliegenden Erfindung können Scheiben aus Halbleitermaterial hergestellt werden, indem die folgenden Schritte durchgeführt werden: Ziehen eines Einkristallstabs aus Halbleitermaterial gemäß dem Czochralski-Verfahren; Schleifen des Einkristallstabs; Sägen des geschliffenen Einkristallstabs in Scheiben; Schleifen und/oder Läppen der Scheiben; Polieren der Scheiben; und chemisches Reinigen der Scheiben. Nach dem Abschluss des Ziehens kann der Kristallstab also in dieser Reihenfolge in Stücke gesägt und geschliffen, in Scheiben gesägt, die Scheiben anschließend geschliffen oder geläppt, poliert, chemisch gereinigt und so Halbleiterscheiben erhalten werden. In diesem Verfahren wird zudem das Verfahren gemäß dem ersten Aspekt der vorliegenden Erfindung stichprobenartig im Rahmen der Prozesskontrolle durchgeführt. Dadurch kann einerseits die chemische Zusammensetzung der Verunreinigungen an der Oberfläche der hergestellten Scheiben aus Halbleitermaterial mit hoher Empfindlichkeit nachgewiesen werden und zudem die Ursache der Verunreinigungen identifiziert werden. Dies ermöglicht es, in den Prozess einzugreifen und die Quelle der Verunreinigungen zu beseitigen. Dadurch kann eine gleichbleibende, hohe Qualität der Oberflächen der Scheiben aus Halbleitermaterial gewährleistet werden.

Ein weiterer Vorteil der vorliegenden Erfindung ist es, dass Scheiben aus unterschiedlichen Halbleitermaterialine, beispielsweise Scheiben aus einkristallinem Silizium mit unterschiedlichen Dotierstoffen, in derselben Produktionslinie verarbeitet werden können, weil Verunreinigungen und deren Ursache durch das erfindungsgemäße Verfahren im Rahmend der Prozesskontrolle identifiziert und somit die Ursachen oder Quellen der Verunreinigungen beseitigt werden können.

### Ausführungsbeispiele

### Ausführungsbeispiel 1

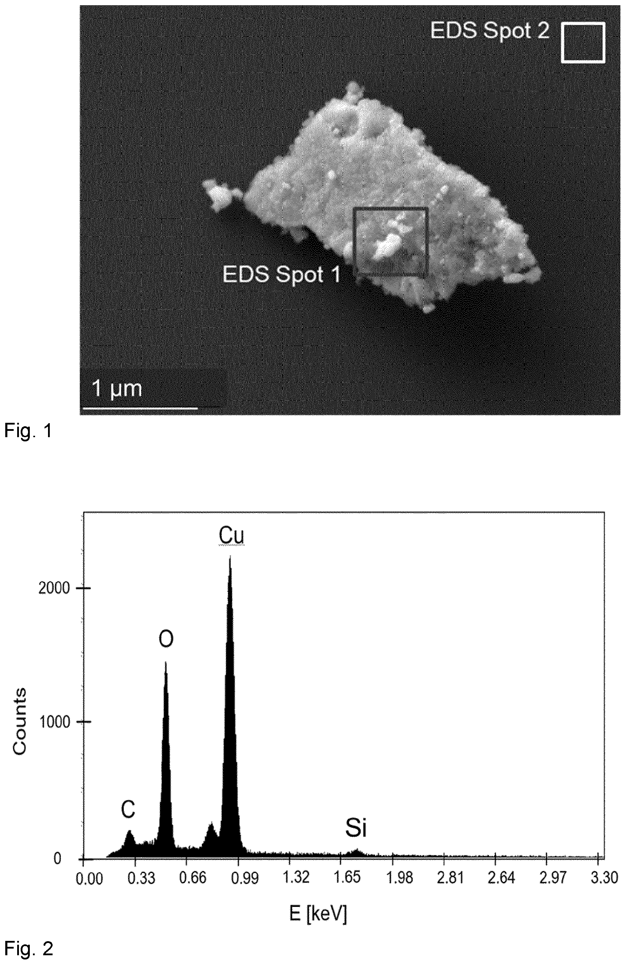

Im Ausführungsbeispiel 1 wurde eine Scheibe aus einkristallinem Silizium mit einem Durchmesser von 300 mm mittels Lichtstreumessung mit einem Gerät der Hersteller KLA Tencor Corp. oder Hitachi High-Tech Corp untersucht und so die Position und Größe von Oberflächendefekten auf der Scheibe identifiziert. Die Positionen sowie die Größen der Oberflächendefekte wurden wie oben beschrieben in einem elektronischen Format als KLARF-Datei festgehalten und gespeichert. Anschließend wurde die KLARF-Datei auf einen mit einem Rasterelektronenmikroskop des Typs Auriga des Herstellers Zeiss verbundenen Rechner übertragen und einer der größten Oberflächendefekte/Partikel mit dem Rasterelektronenmikroskop untersucht und dabei das in Fig. 1 dargestellte Bild des Oberflächendefektes aufgenommen. Das Rasterelektronenmikroskop des Typs Auriga 60 war sowohl mit einem EDX-Gerät des Typs Octane Elite des Herstellers AMETEK EDAX, als auch mit einem SIMS-Gerät des TYPS EQS Herstellers Hiden Analytical gekoppelt. Die laterale Auflösung lag im Bereich von 50 bis 200 nm.

Der in Fig. 1 abgebildete Partikel hatte eine maximale Ausdehnung von ca. 2 µm. Es wurden zunächst eine Analyse des Partikels mittels energiedispersiven Röntgenspektroskopie (EDX) durchgeführt. Im selektierten Bereich (EDS-Spot 1 in Fig. 1) auf dem Partikel wurde neben Silizium, Sauerstoff und Kohlenstoff vor allem Kupfer gefunden, wie Fig. 2 zeigt. Üblicherweise wird Kupfer in der Halbleiterfertigung jedoch nicht in metallischer Reinstform verwendet, so dass seinem Auftreten keine bestimmte Ursache zugeordnet werden kann. Eine EDX-Referenzmessung neben dem Partikel (EDS-Spot 2 in Fig. 1) zeigte erwartungsgemäß nur Silizium.

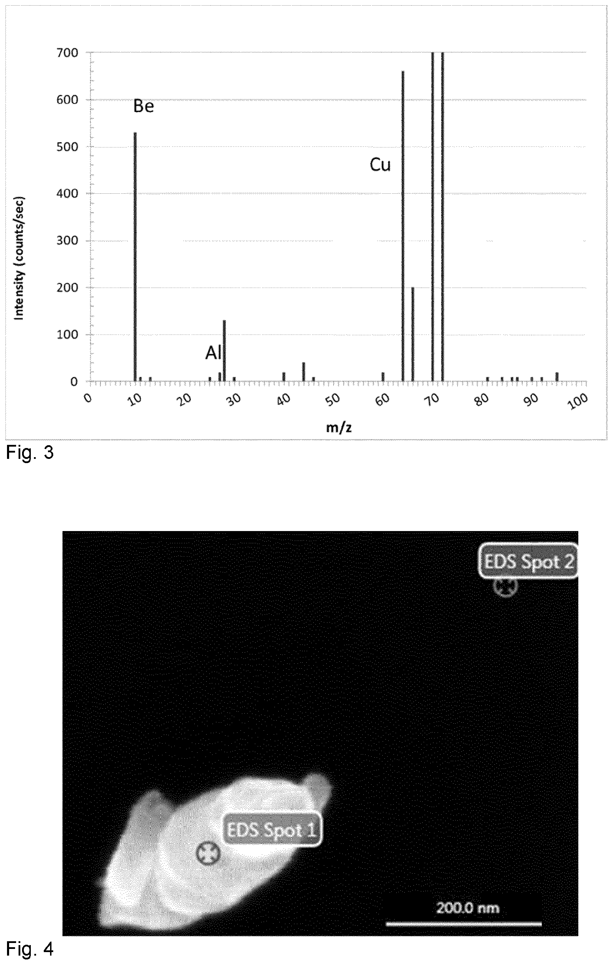

Eine nachfolgend durchgeführte Analyse mittels SIMS bestätigte die Befunde der EDX-Analyse. Zusätzlich zu Silizium und Kupfer wurden Beryllium sowie geringe Mengen an Aluminium (Massenzahl 27) identifiziert, beide letztgenannten Elemente konnten mittels EDX nicht nachgewiesen werden. Das zugehörige Massenspektrum ist in Fig. 3 abgebildet. Die Kombination dieser drei Elemente ist charakteristisch für eine Legierung aus Kupfer-Aluminium-Beryllium, welche in Federmaterialien Verwendung findet. Zusätzlich wurde eine Nachverfolgung des Ablaufs der betroffenen Halbleiterscheibe in der Produktionslinie durchgeführt und so eine Feder, welche in einem Klemm-Mechanismus für die Halbleiterscheiben verbaut ist, als Ursache der Verunreinigung mit dem Fremdmaterial identifiziert.

### Ausführungsbeispiel 2

Im Ausführungsbeispiel 2 wurde mit einer weiteren Scheibe aus einkristallinem Silizium und einem Durchmesser von 300 mm wie im Ausführungsbeispiel 1 verfahren. Es wurden zunächst die Position und Größe von Oberflächendefekten auf der Scheibe mittels Lichtstreumessung identifiziert und diese als KLARF-Datei festgehalten und gespeichert. Anschließend wurde die KLARF-Datei auf das im Ausführungsbeispiel 1 verwendete Rasterelektronenmikroskop übertragen und einer der Oberflächendefekte/Partikel mit dem Rasterelektronenmikroskop untersucht und dabei das in Fig. 4 dargestellte Bild des Oberflächendefektes aufgenommen.

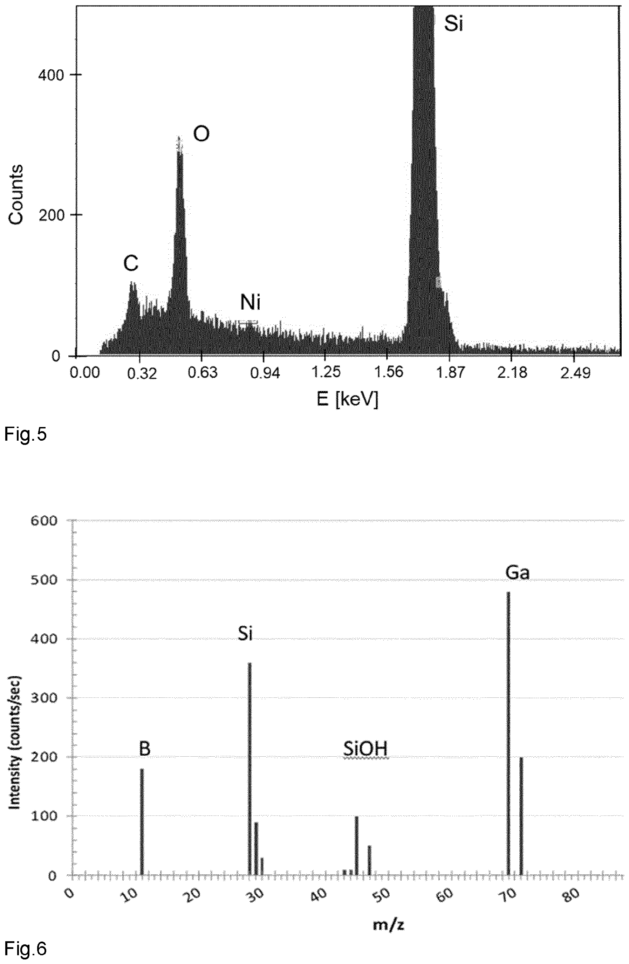

Es wurden zunächst eine Analyse des Partikels mittels EDX durchgeführt. Im selektierten Bereich auf dem Partikel (EDS-Spot 1 in Fig. 4) wurden neben Silizium vor allem Sauerstoff, Kohlenstoff und sehr geringe Mengen Nickel, die vernachlässigt werden können, detektiert. Die Ergebnisse der EDX-Analyse sind in Fig. 5 dargestellt. Eine EDX-Referenzmessung neben dem Partikel (EDS-Spot 2 in Fig. 4) zeigte erwartungsgemäß nur Silizium. Da die Elemente Sauerstoff, Kohlenstoff und Nickel zusammen in diversen Vorrichtungen, die im Herstellungsprozess von Scheiben aus einkristallinem Silizium eingesetzt werden, anzutreffen sind, konnte auf der Grundlage der EDX-Analyse kein bestimmtes Fremdmaterial und keine bestimmte Ursache für diese Verunreinigung zugeordnet werden können.

Eine nachfolgend durchgeführte Analyse mittels SIMS bestätigte die Befunde der EDX-Analyse. Zusätzlich zu Sauerstoff und Kohlenstoff wurden Bor und Gallium identifiziert, die mittels EDX nicht detektiert wurde. Das detektierte Gallium stammt aus der anregenden Ionenquelle des verwendeten SIMS-Gerätes und hat für die Bestimmung der chemischen Zusammensetzung keine Bedeutung. Das zugehörige Massenspektrum ist in Fig. 6 abgebildet. Die Kombination der Elemente Sauerstoff, Kohlenstoff und Bor ist charakteristisch für einen Partikel eines Poliermittels aus SiO₂, welcher in einem chemo-mechanischen Abtragsprozess mit einer Bor-dotierten Halbleiterscheibe in Wechselwirkung war. Zusätzlich wurde eine Nachverfolgung des Ablaufs der betroffenen Halbleiterscheibe in der Produktionslinie durchgeführt und so die Poliermaschine und das Poliermittel, welches die Ursache der Verunreinigung mit dem Fremdmaterial war, identifiziert.

### Ausführungsbeispiel 3

Im Ausführungsbeispiel 3 wurden die EDX-Analysen sowie die SIMS-Analysen von einerseits einer polierten Scheibe aus einkristallinem Silizium mit einem Durchmesser von 300 mm und andererseits einer Substratscheibe aus einkristallinem Silizium mit einem Durchmesser von 300 mm und einer darauf epitaktisch abgeschiedenen Schicht aus Silizium untersucht.

Dabei wurde für jede Scheibe eine EDX-Analyse sowie eine SIMS-Analyse wie in den Ausführungsbeispielen 1 und 2 beschrieben durchgeführt. Die beiden EDX-Spektren zeigten jeweils lediglich ein Signal, das Silizium zugeordnet werden kann. In der nachfolgend durchgeführten Analyse mittels SIMS wurde zusätzlich zu Silizium Bor detektiert. Dabei wurde auf der Oberfläche beider Scheiben ein Fremdstoffkonzentration der Borisotope ¹⁰Bor und ¹¹Bor im Bereich von 1 ×10¹⁸ bis 3×10¹⁹ Atome/cm³ detektiert. Damit können mittels Sekundärionen-Massenspektrometrie auch Partikel aus Scheiben, die aus Bor-dotierten einkristallinem Silizium bestehen, identifiziert und einem Material zugeordnet werden. Somit können auch Verunreinigungen durch andere Scheiben aus Halbleitermaterial, die in derselben Produktionslinie bearbeitet wurden, identifiziert und bestimmten Scheiben zugeordnet werden. Dies ermöglicht es, Scheiben aus unterschiedlichen Halbleitermaterialien in derselben Vorrichtung zu bearbeiten, da eventuell Verunreinigungen durch ein anderes Halbleitermaterial zuverlässig detektiert und die Ursachen der Verunreinigungen beseitigt werden können.

Die Ausführungsbeispiele 1 bis 3 zeigen, dass das erfindungsgemäße Verfahren zur Identifizierung der Ursache von Verunreinigungen von Scheiben aus Halbleitermaterial besser geeignet ist als konventionelle Verfahren, um die chemische Zusammensetzung von Partikeln auf der Oberfläche von Scheiben aus Halbleitermaterial zu identifizieren und einer Ursache zuordnen zu können. Damit kann der Prozessschritt, die Vorrichtung, der Hilfsstoff oder der Werkstoff, der die Verunreinigung mit dem Fremdmaterial verursacht hat, leichter identifiziert und zukünftige Verunreinigungen vermieden werden, indem die Ursache der Verunreinigung behoben wird.

## Patentansprüche

1. Verfahren zur Identifizierung der Ursache von Verunreinigungen von Scheiben aus Halbleitermaterial, umfassend die folgenden Schritte:
(i) Auswählen mindestens einer Scheibe aus Halbleitermaterial;
(ii) Identifizieren der Positionen und Größen von Oberflächendefekten auf der mindestens einen, ausgewählten Scheibe aus Halbleitermaterial mittels Lichtstreumessung;
(iii) Auswählen mindestens eines der im Schritt (ii) identifizierten Oberflächendefekte und Bestimmen der chemischen Zusammensetzung mindestens eines Teils des ausgewählten mindestens einen Oberflächendefektes mittels Sekundärionen-Massenspektrometrie; und
(iv) Identifizieren eines Prozessschrittes im verwendeten Herstellungsprozess der Scheiben aus Halbleitermaterial, in dem ein Werkstoff, ein Hilfsstoff oder eine Verunreinigung auftritt, die ein Fremdmaterial mit der bestimmten chemischen Zusammensetzung umfasst.

2. Verfahren zur Identifizierung der Ursache von Verunreinigungen von Scheiben aus Halbleitermaterial gemäß dem Anspruch 1, **dadurch gekennzeichnet, dass** im Schritt (iii) zusätzlich das Isotopenverhältnis von einem oder mehreren detektierten chemischen Elementen der chemischen Zusammensetzung bestimmt wird.

3. Verfahren zur Identifizierung der Ursache von Verunreinigungen von Scheiben aus Halbleitermaterial gemäß dem Anspruch 1 oder 2, **dadurch gekennzeichnet, dass** im Schritt (iii) das Auswählen mindestens eines der im Schritt (ii) identifizierten Oberflächendefekte mittels energiedispersive Röntgenspektroskopie erfolgt.

4. Verfahren zur Identifizierung der Ursache von Verunreinigungen von Scheiben aus Halbleitermaterial gemäß einem der Ansprüche 1 bis 3, **dadurch gekennzeichnet, dass** der Schritt (iii) mit Hilfe eines Rasterelektronenmikroskops, das mit einem Sekundärionen-Massenspektrometrie-Gerät, und optional mit einem Detektor für energiedispersive Röntgenspektroskopie, ausgestattet ist, durchgeführt wird.

5. Verfahren zur Identifizierung der Ursache von Verunreinigungen von Scheiben aus Halbleitermaterial gemäß einem der Ansprüch1 bis 4, **dadurch gekennzeichnet, dass**
im Schritt (i) mehrere Scheiben aus Halbleitermaterial ausgewählt werden, die nach unterschiedlichen Prozessschritten aus dem Herstellungsprozess entnommen werden;
die Schritte (ii) und (iii) für jede der ausgewählten Scheiben aus Halbleitermaterial durchgeführt werden; und
im Schritt (iii), für jede der ausgewählten Scheiben Oberflächendefekte mit der gleichen, bestimmten chemischen Zusammensetzung gesucht werden.

6. Verfahren zur Identifizierung der Ursache von Verunreinigungen von Scheiben aus Halbleitermaterial gemäß dem Anspruch 5, **dadurch gekennzeichnet, dass**
die Schritte (ii) und (iii) zuerst für eine der mehreren ausgewählten Scheiben aus Halbleitermaterial durchgeführt werden und so eine bestimmte, chemische Zusammensetzung identifiziert wird; und
die Schritte (ii) und (iii) für die verbleibenden ausgewählten Scheiben aus Halbleitermaterial durchgeführt werden und dabei im Schritt (iii) gezielt nach einem Teil eines Oberflächendefektes gesucht wird, der die bestimmte chemische Zusammensetzung aufweist.

7. Verfahren zur Identifizierung der Ursache von Verunreinigungen von Scheiben aus Halbleitermaterial gemäß dem Anspruch 6, **dadurch gekennzeichnet, dass**
die Scheibe aus Halbleitermaterial, für die zuerst der Schritt (iii) durchgeführt und eine bestimmte, chemische Zusammensetzung identifiziert wird, diejenige Scheibe aus Halbleitermaterial ist, die im Vergleich zu den verbleibenden ausgewählten Scheiben aus Halbleitermaterial die meisten Prozessschritte des Herstellungsprozesses durchlaufen hat.

8. Verfahren zur Identifizierung der Quelle von Verunreinigungen von Scheiben aus Halbleitermaterial gemäß einem der Ansprüche 1 bis 7, **dadurch gekennzeichnet, dass** das Verfahren zusätzlich einen Schritt umfasst, in dem die chemische Zusammensetzung einem Fremdmaterial zugeordnet wird.

9. Verfahren zur Identifizierung der Quelle von Verunreinigungen von Scheiben aus Halbleitermaterial gemäß dem Anspruch 8, **dadurch gekennzeichnet, dass** die Zuordnung einer chemischen Zusammensetzung zu einem Fremdmaterial mithilfe einer Datenbank erfolgt, wobei die Datenbank die chemische Zusammensetzung verschiedener Fremdmaterialien, und optional das Isotopenverhältnis eines oder mehrere Elemente der chemischen Zusammensetzung, angibt.

10. Verfahren zur Identifizierung der Quelle von Verunreinigungen von Scheiben aus Halbleitermaterial gemäß dem Anspruch 9, **dadurch gekennzeichnet, dass** die Datenbank angibt, in welchem Werkstoff, Hilfsstoff oder anderen Halbleitermaterial der Fremdstoff enthalten ist.

11. Verfahren zur Herstellung von Scheiben aus Halbleitermaterial, umfassend die folgenden Schritte:
Ziehen eines Einkristallstabs aus Halbleitermaterial gemäß dem Czochralski-Verfahren;
Schleifen des Einkristallstabs;
Sägen des geschliffenen Einkristallstabs in Scheiben;
Schleifen und/oder Läppen der Scheiben;
Polieren der Scheiben; und
chemisches Reinigen der Scheiben,
**dadurch gekennzeichnet, dass** das Verfahren gemäß dem Ansprüchen 1 bis 10 stichprobenartig im Rahmen der Prozesskontrolle durchgeführt wird.
